# FASCICULE DE BREVET EUROPEEN

(11) **EP 2 750 170 B1**
(45) Date de publication et mention de la délivrance du brevet: **11.04.2018**
(21) Numéro de dépôt: 13199218.2
(22) Date de dépôt: 20.12.2013
(51) Int. Cl.: H01L 21/311, H01L 21/02, H01L 29/66, H01L 21/265, H01L 21/3115, H01L 21/306, H01L 21/3065

(54) **Procédé de formation des espaceurs d'une grille d'un transistor**
Verfahren zur Bildung von Abstandshaltern eines Gates eines Transistors
Method for forming spacers of a transistor gate

(30) Priorité: 28.12.2012 FR 1262962
(43) Date de publication de la demande: 02.07.2014
(73) Titulaire: COMMISSARIAT À L'ÉNERGIE ATOMIQUE ET AUX ÉNERGIES ALTERNATIVES, 75015 Paris (FR); Centre National de la Recherche Scientifique, 75016 Paris (FR); Applied Materials, Inc., Santa Clara, CA 95050 (US)
(72) Inventeur: Posseme, Nicolas, 38000 Grenoble (FR); David, Thibaut, 38570 Goncelin (FR); Joubert, Olivier, 38240 Meylan (FR); Lill, Torsten, Santa Clara, 95050 Californie CA California (US); Nemani, Srinivas, Santa Clara, 95050 Californie CA California (US); Vallier, Laurent, 38240 Meylan (FR)
(74) Mandataire: Hautier, Nicolas

(56) Documents cités:
- WO-A1-2004/059725
- WO-A1-2011/054560
- JP-A- S59 181 539
- US-A- 4 956 314
- US-A1- 2004 087 155
- US-B1- 6 380 030
- André Anders: "Handbook of Plasma Immersion Ion Implantation and Deposition", , 3 octobre 2000 (2000-10-03), pages 637-681, XP055098427, ISBN: 978-0-47-124698-5 Extrait de l'Internet: URL:www6.cityu.edu.hk/appkchu/Publications /2000/00.12.pdf [extrait le 2014-01-24]

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

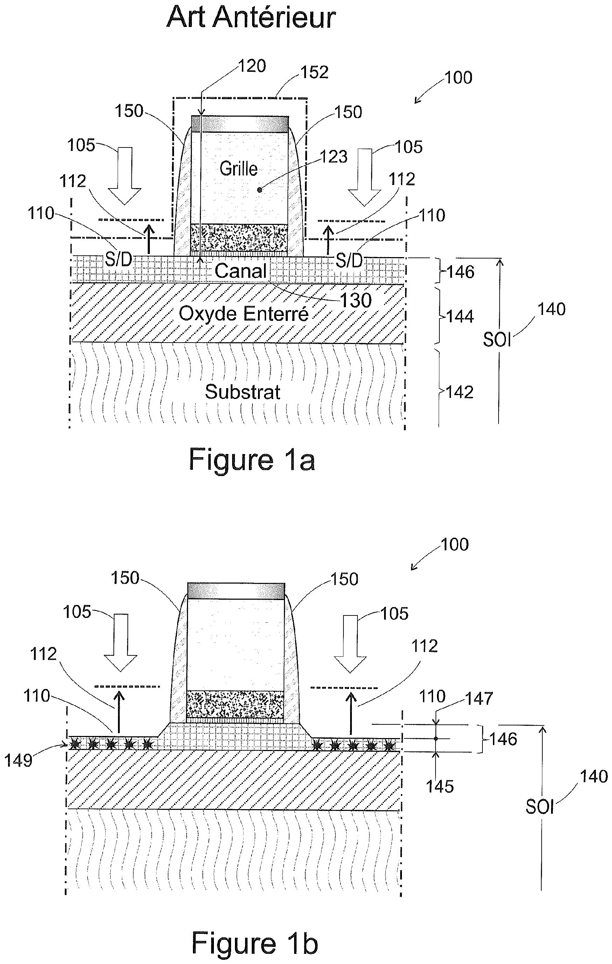

La **figure 1a** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut apparaissent lors de la mise en oeuvre des solutions connues.

La présente invention a pour objet de proposer un procédé de formation d'espaceurs jouant pleinement leur rôle d'isolation et qui supprimerait ou limiterait les défauts dans la réalisation de transistors.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille étant située au dessus d'une couche en un matériau semi-conducteur de préférence destinée à former un canal de conduction pour le transistor. Le procédé comprend une étape de formation d'une couche de nitrure recouvrant la grille du transistor, la couche de nitrure de silicium recouvrant au moins un sommet et des flancs de la grille. Le procédé comprend les étapes suivantes:
après l'étape de formation de la couche de nitrure, au moins une étape de modification de la couche de nitrure par implantation d'ions légers au sein de la couche de nitrure pour former une couche modifiée de nitrure, l'étape de modification étant réalisée de manière à ne pas modifier la couche de nitrure sur toute son épaisseur au niveau de flancs de la grille;
au moins une étape de retrait de la couche modifiée de nitrure à l'aide d'une gravure sélective de la couche modifiée de nitrure vis-à- vis dudit matériau semiconducteur et vis-à-vis de la couche de nitrure non modifiée.

De manière particulièrement avantageuse, la modification de la couche de nitrure par implantation d'ions légers, typiquement de l'hydrogène (H2) ou de l'hélium (He), permet d'améliorer considérablement la sélectivité de cette couche par rapport au matériau semi-conducteur, typiquement du silicium. Cette implantation fait également que l'épaisseur de nitrure modifiée se grave plus rapidement que le nitrure non modifiée.

La gravure consomme ainsi la couche de nitrure modifiée préférentiellement à la couche de matériau semi-conducteur et à la couche de nitrure non modifiée. Ainsi, le risque de consommation excessive de la couche superficielle de matériau semi-conducteur est réduit voir supprimé.

De préférence, la modification de la couche de nitrure conserve une épaisseur de nitrure non modifié sur les flancs de la grille. Cette épaisseur est conservée, au moins en partie, lors de la gravure sélective. Elle définie alors des espaceurs de grille.

L'invention permet ainsi d'obtenir des espaceurs de nitrure tout en réduisant voire en éliminant les problèmes des solutions connues et mentionnés précédemment.

Selon un mode de réalisation particulièrement avantageux, l'implantation est réalisée à partir d'un plasma comprenant lesdits ions légers.

L'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur de nitrure, typiquement comprise entre 1 et 10 nm et plus généralement entre 1 et 30 nm.

L'étape de modification réalisée à partir d'un plasma modifie la couche de nitrure de manière continue depuis la surface de la couche de nitrure et sur une épaisseur comprise entre 1 nm et 30nm et de préférence entre 1nm et 10 nm.

Selon un mode de réalisation particulièrement avantageux, l'implantation et le retrait de la couche de nitrure sont réalisées dans un même réacteur plasma. Une modification de la couche à retirer réalisée par une implantation par plasma permet ainsi d'effectuer la modification de la couche et la gravure dans une même chambre ce qui est très avantageux en termes de simplification, de temps et de coût du procédé.

L'invention s'avère particulièrement avantageuse pour la formation d'espaceurs de transistors FDSOI ou FinFET par exemple.

De manière également avantageuse, la modification de la couche de nitrure par implantation d'ions légers tels que l'hydrogène (H2) ou l'hélium (He) permet également d'améliorer la sélectivité de cette couche de nitrure modifiée par rapport à l'oxyde du matériau semi-conducteur. Typiquement, dans le cas d'un transistor FinFET, la couche de nitrure modifiée est retirée des fins alors que l'oxyde de grille n'est pas consommé ou est moins consommé.

De manière facultative, le procédé peut en outre présenter au moins l'une quelconque des caractéristiques et étapes ci-dessous :
De préférence, les paramètres de l'implantation, notamment l'énergie d'implantation des ions légers et la dose implantée, sont prévues de sorte que la couche de nitrure modifiée puisse être gravée de manière sélective vis-à-vis dudit matériau semiconducteur et vis-à-vis de la couche de nitrure non modifiée.

Selon un mode de réalisation, la couche de nitrure est une couche de nitrure de silicium.

Selon un mode de réalisation, l'étape de modification de la couche de nitrure de silicium est précédée d'une étape principale de gravure anisotrope. De préférence, l'étape principale de gravure anisotrope consiste en une gravure sèche dans un plasma à base de fluorure de méthyle (CH3F).

Selon un mode de réalisation, l'étape de modification comprend la mise en présence de la couche de nitrure de silicium avec un plasma comprenant les ions légers dans un réacteur de gravure.

Selon un autre mode de réalisation, l'étape de modification par implantation des ions légers est effectuée à l'aide d'un implanteur.

On entend par « ions légers » des ions provenant de matériaux dont le numéro atomique dans la classification périodique des éléments est faible. D'une façon générale tous les éléments que l'on peut implanter dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

De préférence, les ions légers sont pris parmi l'hydrogène (H2) et l'hélium (He) dont les numéros atomiques sont respectivement 1 et 2. Plus généralement, les ions légers sont pris parmi les espèces dont le numéro atomique est inférieur ou égal à 10. Une seule ou plusieurs de ces espèces peuvent être implantées.

Selon un mode de réalisation, l'étape de retrait de la couche de nitrure de silicium modifiée est effectuée par gravure humide sélective audit matériau semiconducteur. De préférence, le matériau semi-conducteur est du silicium et l'étape de retrait de la couche de nitrure de silicium modifiée est effectuée par gravure humide sélectivement au silicium (Si) et/ou à l'oxyde de silicium (SiO2).

Le matériau semi-conducteur peut également être du germanium (Ge) ou du silicium-germanium SiGe. L'étape de retrait de la couche de nitrure de silicium modifiée est effectuée par gravure humide sélectivement au Ge ou au SiGe ou et/ou à de l'oxyde de SiGe ou de l'oxyde de Ge.

De préférence, la gravure sélective au silicium est obtenue à l'aide d'une solution à base d'acide fluorhydrique (FH) ou à l'aide d'une solution à base d'acide phosphorique (H3PO4).

Selon un autre mode de réalisation, l'étape de retrait est effectuée par gravure sèche sélective audit matériau semiconducteur. De préférence, l'étape de retrait de la couche modifiée de nitrure de silicium est effectuée par gravure sèche sélective au silicium (Si) et/ou à l'oxyde de silicium (SiO2). Selon un mode de réalisation, la gravure sèche est effectuée dans un plasma formé dans une enceinte confinée à partir de trifluorure d'azote (NF3) et d'ammoniac (NH3).

Avantageusement, la gravure sèche comprend : une étape de gravure consistant en la formation de sels solides; une étape de sublimation des espèces solides. Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.

Avantageusement, l'implantation est effectuée de manière à modifier toute l'épaisseur de la couche de nitrure en dehors de la couche de nitrure disposée sur les flancs de la grille. Ainsi, la gravure retire toute la couche de nitrure à l'exception d'une partie au moins de la couche de nitrure située sur les flancs de la grille.

Avantageusement, l'épaisseur de la couche de nitrure modifiée sur les flancs de la grille est nulle ou est inférieure à l'épaisseur de la couche de nitrure avant modification par implantation.

Avantageusement, l'implantation modifie la couche de nitrure depuis sa surface et jusqu'à profondeur correspondant à une partie au moins de son épaisseur. De préférence, l'implantation modifie la couche de nitrure de manière ininterrompue depuis surface.

Selon un mode de réalisation particulier, le procédé comprend une unique étape de modification effectuée de sorte à modifiée la couche de nitrure de silicium dans toute son épaisseur sur toutes les surfaces parallèles au plan d'un substrat sur lequel repose la grille et à ne pas modifier la couche de nitrure de silicium dans toute son épaisseur sur les surfaces perpendiculaires à ce plan. Ces surfaces perpendiculaires à ce plan, c'est-à-dire perpendiculaire à la couche en un matériau semi-conducteur formant un canal de conduction ou au substrat massif sont typiquement parallèles aux flancs de la grille du transistor. Ainsi, suite à cette unique étape de modification, une gravure sélective de la couche modifiée de nitrure de silicium permet de retirer la couche de nitrure de silicium sur toutes les surfaces exceptées sur celles parallèles aux flancs de la grille.

Selon un autre mode de réalisation, le procédé comprend plusieurs séquences comprenant chacune une étape de modification et une étape de retrait. Au cours d'au moins l'une des étapes de modification, seule une partie de l'épaisseur de la couche de nitrure de silicium est modifiée. Avantageusement, les séquences sont répétées jusqu'à disparition de la couche de nitrure de silicium sur toutes les surfaces parallèles au plan d'un substrat sur lequel repose la grille. Seules les faces parallèles aux flancs de la grille conservent une épaisseur de nitrure de silicium, cette épaisseur n'ayant pas fait l'objet de modification par implantation.

Selon l'invention, la couche de nitrure est disposée directement au contact de la couche en un matériau semi-conducteur. De préférence la couche de nitrure est disposée directement au contact de la grille qui est de préférence formée dans un matériau semi-conducteur.

Avantageusement, la grille du transistor est située sur un empilement de couches formant un substrat élaboré de type silicium sur isolant (SOI). De préférence, elle est disposée directement au contact de la couche formant le canal de conduction. Avantageusement, l'utilisation de l'invention avec un tel substrat SOI permet de préserver l'intégrité de la couche superficielle de très faible épaisseur qui forme le canal de conduction d'un transistor formé à partir d'un substrat SOI.

Avantageusement, le matériau semi-conducteur est du silicium.

Avantageusement, la gravure est sélective à l'oxyde de silicium (SiO2).

Alternativement, le matériau semi-conducteur est pris parmi: le germanium (Ge), le silicium germanium (SiGe).

Selon un mode de réalisation, le transistor est un transistor de type FDSOI. De préférence, le procédé comprend une étape de retrait complet de la couche de nitrure en dehors des flancs et de part et d'autre de la grille pour mettre à nu la couche en un matériau semi-conducteur et une étape de formation de zones de source drain à partir de la couche en un matériau semi-conducteur, par exemple par épitaxie.

Selon un autre mode de réalisation, le transistor est un transistor de type FinFET.

Selon un mode de réalisation, l'implantation d'ions est réalisée par au moins deux et de préférence trois implantations présentant des directions d'implantation différentes et dans lequel pour modifier la direction de l'implantation, on incline la couche de nitrure. L'invention permet de retirer en partie au moins la couche de nitrure sur toutes les surfaces d'un motif. Typiquement, ce motif est un fin (nageoire) d'un transistor FinFET.

De préférence, l'implantation d'ions comprend une première implantation anisotrope réalisée selon une direction sensiblement perpendiculaire à une couche sur laquelle le motif est situé, une deuxième implantation réalisée selon une direction non parallèle à des premiers flancs du motif et de manière à implanter des ions légers dans les premiers flancs, une troisième implantation réalisée selon une direction non parallèle à des deuxièmes flancs du motif et de manière à implanter des ions légers dans les deuxièmes flancs. Les étapes d'implantation et de retrait sont effectuées de manière à retirer, lors de l'étape de retrait, la couche de nitrure située en dehors des flancs et une partie au moins de la couche de nitrure recouvrant les premiers et les deuxièmes flancs. Selon un premier mode de réalisation, une implantation est réalisée de manière à modifier la couche de nitrure recouvrant lesdits flancs sur une profondeur correspondant à une portion seulement de l'épaisseur de la couche de nitrure recouvrant lesdits flancs. L'épaisseur de la couche que l'on conserve sur le motif peut alors être ajustée avec précision. Selon un premier mode de réalisation, une implantation est réalisée de manière à modifier la couche de nitrure recouvrant lesdits flancs sur une profondeur correspondant à toute l'épaisseur de la couche de nitrure recouvrant lesdits flancs. Toute la couche de nitrure recouvrant le motif peut alors être retirée. C'est ce mode de réalisation que l'on applique pour retirer la couche de nitrure des fins d'un transistor de type FinFET.

Un autre aspect décrit dans la présente description concerne un procédé de gravure d'une couche de nitrure de silicium sélectivement à du silicium (Si) et/ou à de l'oxyde de silicium (SiO2) comprenant :
au moins une étape de modification de tout ou partie de la couche de nitrure de silicium par implantation d'ions légers tels que l'hydrogène (H2) et l'hélium (He) au sein de la couche de nitrure de silicium pour former une couche modifiée de nitrure de silicium;
au moins une étape de retrait de la couche modifiée de nitrure de silicium à l'aide d'une gravure sélective de la couche modifiée de nitrure de silicium vis-à-vis du silicium (Si) et/ou de l'oxyde de silicium (SiO2).

Avantageusement, l'implantation en particulier son énergie, la concentration et la nature des ions légers, la dose utilisée et la durée du procédé d'implantation, sont prévues de sorte que la couche de nitrure modifiée puisse être gravée de manière sélective vis-à-vis du reste de la couche de nitrure, c'est-à-dire à la couche de nitrure non modifiée.

Avantageusement, la modification de la couche de nitrure de silicium par implantation d'hydrogène (H2) ou d'hélium (He) permet d'améliorer la sélectivité de cette couche par rapport au silicium et/ou à l'oxyde de silicium.

De préférence, la gravure est obtenue à l'aide d'une solution à base d'acide phosphorique (H3PO4) ou à l'aide d'une solution à base d'acide fluorhydrique (FH).

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a à 1d montrent, d'une part, une vue en coupe d'un exemple de transistor MOSFET de type FDSOI en cours de réalisation et, d'autre part, illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
Les FIGURES 2a à 2i illustrent la structure tridimensionnelle (3D) d'un exemple de transistor MOSFET de type FinFET et les problèmes de gravure qui se posent dans ce cas.
Les FIGURES 3a à 3d illustrent les étapes d'un exemple de procédé selon l'invention appliqué à la réalisation de transistors de type FDSOI.
La FIGURE 4 résume les étapes d'un exemple de procédé de l'invention destinées à former des espaceurs et qui n'induisent pas ou tout au moins limitent les défauts décrits dans les figures 1b à 1d.
Les FIGURE 5a à 5e illustrent des exemples de conditions typiques de mise en oeuvre de l'étape de modification de la couche de nitrure lors de la formation des espaceurs.
La FIGURE 6 montre les étapes du retrait par voie sèche de la couche de nitrure de silicium qui a été modifiée par implantation, par exemple, d'hydrogène.
Les FIGURES 7a à 7h illustrent un procédé de gravure, ne faisant pas partie de l'invention, qui peut aussi être employé, en combinaison avec l'utilisation d'implanteurs standard, pour pratiquer une gravure isotrope ou une succession de gravures anisotropes dont les directions privilégiées sont différentes.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Dans le cadre de la présente invention plusieurs types de défaut ont été observés lors de la gravure des espaceurs en utilisant l'un ou l'autre des procédés standard de gravure anisotrope développés par l'industrie de la microélectronique.

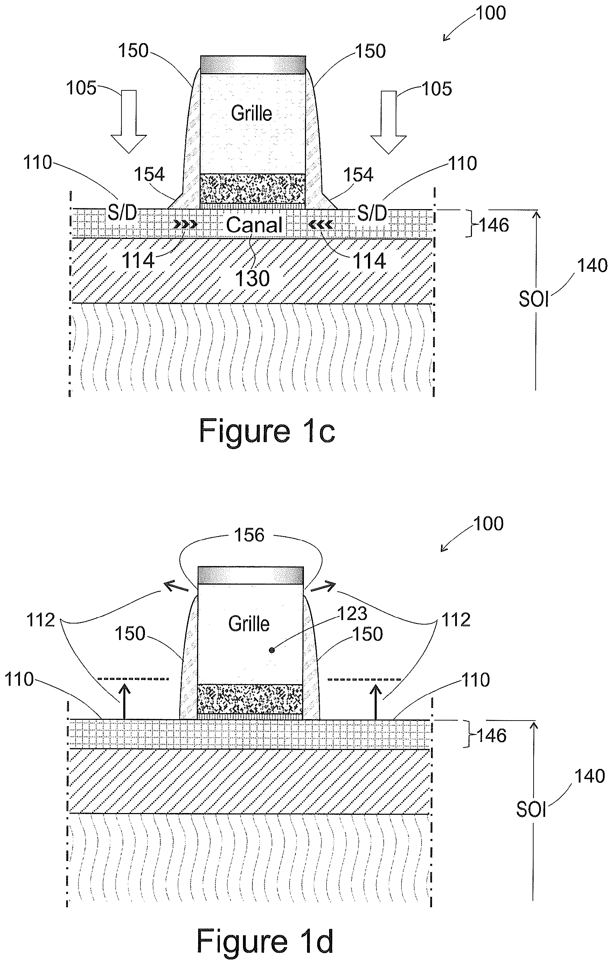

Les **figures 1b****,** **1c et 1d** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (02) et possiblement de l'hélium (He). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène. D'autres gaz réactifs ont été expérimentés comme le méthane (CH4) et l'hexafluorure de soufre (SF6).

L'avantage de ce type de gravure est qu'elle est assez anisotrope et permet de contrôler suffisamment le profile des espaceurs 150 même si l'on ne peut pas obtenir en pratique la forme rectangulaire idéale. L'inconvénient de ce type de gravure est que la sélectivité d'attaque du silicium sous jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4) qui ont une bien meilleure sélectivité, respectivement, vis-à-vis du silicium ou de son oxyde (SiO2) mais qui ne permettent pas cependant de contrôler le profile des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482.

La **figure 1b** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme on l'a vu dans le chapitre sur l'état de la technique la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme on l'a vu dans le chapitre sur l'état de la technique cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 1c** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 1d** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

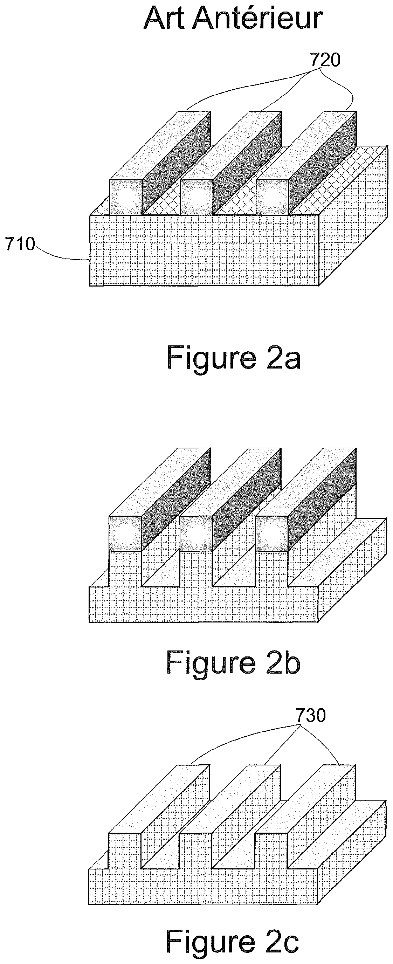

Les **figures 2a à 2i** illustrent comment les problèmes liés à la gravure plasma se posent plus spécifiquement lors de la réalisation de transistors MOSFET de type FinFET, une autre structure de transistor qui commence à être utilisée par l'industrie de la microélectronique pour les noeuds technologiques à partir de celui de 22 nm. Dans la structure FinFET le canal de conduction est constitué d'une mince lamelle verticale de silicium, qualifiée du terme anglais de « fin » c'est-à-dire de « nageoire ». Il est entouré sur trois côtés par la grille de commande. Cela permet notamment d'obtenir des transistors ayant de meilleures performances électriques et aussi de réduire les courants de fuite.

Les figures 2a à 2i décrivent les étapes principales de formation d'un transistor FinFET et les difficultés rencontrées. Les figures 2a, 2b et 2c illustrent plus particulièrement la formation par gravure d'une couche 710 d'un semi-conducteur cristallin, le plus souvent du silicium, des motifs tridimensionnels, c'est-à-dire les « fins », qui vont former les canaux de conduction 730 des transistors. La forme des canaux est définie par un masque dur 720 qui est transféré par gravure dans la couche 710. Cette couche est par exemple la couche superficielle de silicium monocristallin d'un substrat SOI déjà décrit et repose donc sur une couche continue d'oxyde et un substrat (non représentés).

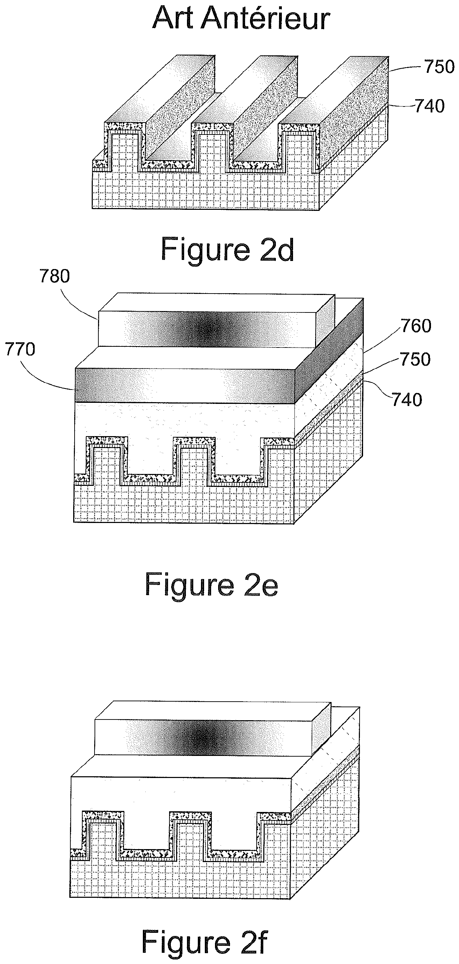

Les figures 2d, 2e et 2f illustrent la formation de la grille des transistors. Comme avec les transistors de type FDSOI la grille est constituée d'un empilement de couches que l'on vient successivement déposer sur les motifs 730 qui vont constituer les canaux. On retrouve donc la fine couche isolante d'oxyde de grille 740 et la couche 750 faite d'un matériau isolant à haute permittivité (high-k) couverte par une grille métallique (metal gate). Le tout est recouvert par une couche de silicium polycristallin 760 qui a été aplanie et sur laquelle on dépose et définit par photolithographie les masques durs 770 et 780 qui vont permettre par gravure de l'empilement des couches ci-dessus de former la grille ainsi que les électrodes source et drain des transistors.

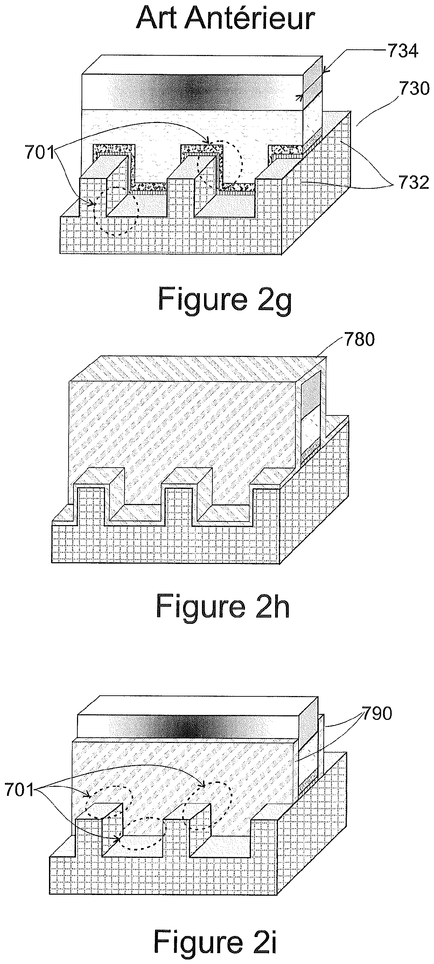

Les figures 2g, 2h et 2i illustrent les opérations suivantes où l'on procède à la gravure des couches de grille ce qui permet de libérer, à partir de chaque motif 730, les zones de source et de drain 732 de part et d'autre de la grille et de définir la longueur des canaux 734. Comme avec les transistors de type FDSOI on a aussi besoin d'espaceurs. Ils sont obtenus, après dépôt d'une couche continue 780 faite généralement de nitrure de silicium, à l'aide d'une gravure très anisotrope de cette couche qui ne laisse en place que les motifs verticaux 790 sur les flancs de la grille.

Comme les transistors FDSOI, les transistors de type FinFET souffrent donc pour leur réalisation des limitations et imperfections de la gravure plasma. En particulier, pour réaliser cette structure de transistor, la gravure utilisée doit avoir une excellente sélectivité vis-à-vis du silicium (Si) et de son oxyde (SiO2) ce qui est difficile à obtenir, comme on l'a vu, avec une gravure plasma. Comme indiqué sur les figures 2g et 2i l'intégrité des angles des motifs gravés en est affectée. En effet, pour que le transistor FinFET présente de bonnes performances, les arêtes 701 des « fins » doivent former des angles qui soient les plus droits possible, tout arrondi de ces angles entraînant une réduction des performances du transistor. Il en est de même pour l'angle que forme les espaceurs et la couche sur laquelle elle repose, typiquement la couche de silicium. Cet angle est indiqué en pointillé sur la figure 7i.

Pour les raisons indiquées ci-dessus, les solutions actuelles reposant sur les gravures plasma ne permettent pas d'obtenir des arêtes formant des angles droits.

On voit donc que la gravure plasma, si elle a permis de suivre les réductions de taille des motifs à chaque introduction d'un nouveau noeud technologique dans les années passées, pose cependant de plus en plus de problèmes quand la taille diminue, en particulier au-delà du noeud technologique de 22 nm. La mise en oeuvre de la gravure plasma pour ces dimensions introduit un degré de complexité supplémentaire pour essayer de pallier les problèmes décrits ci-dessus. Des chimies de gravure plus complexes que celle traditionnelle, dite fluorocarbonée, ont été testées qui nécessitent d'introduire des gaz supplémentaires dans la chambre de gravure. Jusqu'à cinq gaz différents ont été combinés pour former le plasma de gravure. Cela a pour conséquence première de complexifier considérablement le procédé.

Le caractère tridimensionnel (3D) de la structure FinFET fait que les problèmes exposés précédemment pour la réalisation des transistors de type FDSOI se posent avec encore plus d'acuité pour la réalisation des FinFET. On notera par ailleurs que la réalisation de cette structure demande que l'on ait recours non seulement à une gravure anisotrope pour la réalisation des espaceurs 790 sur les flancs des électrodes de grille mais que l'on puisse également graver les flancs des électrodes source/drain 732 en ayant recours à une gravure isotrope.

Comme on l'a vu un objet de l'invention est de s'affranchir de tous ou d'au moins certains de ces problèmes.

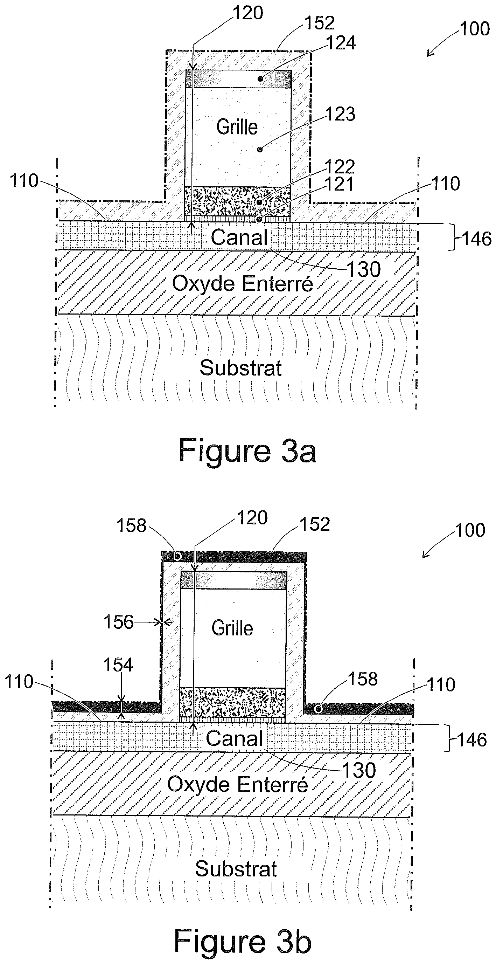

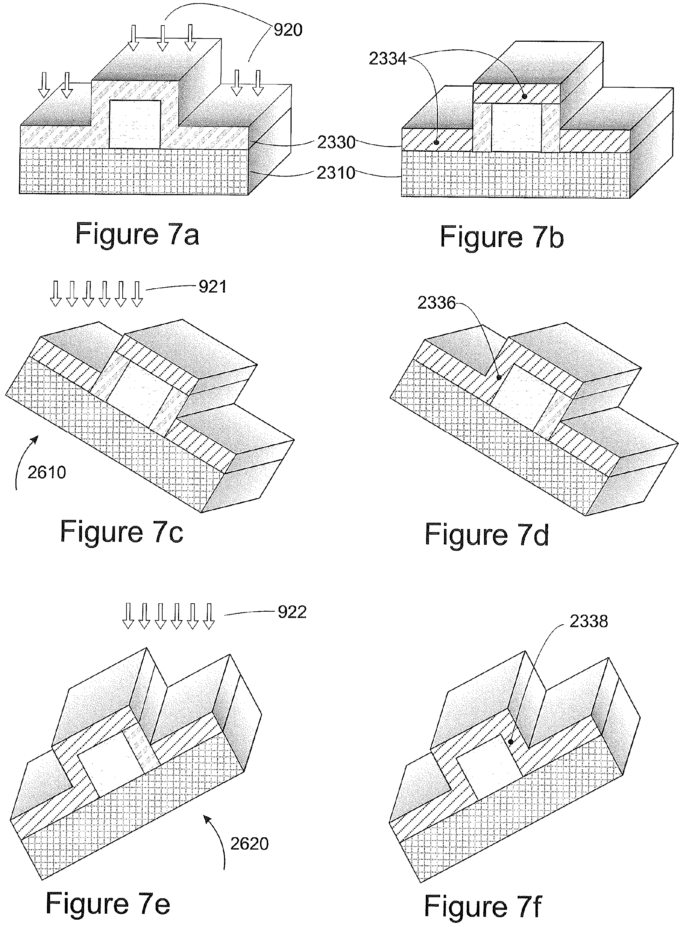

À cette fin, les **figures 3a à 3d** décrivent les étapes d'un exemple détaillé d'un procédé selon l'invention appliqué à la réalisation de transistors de type FDSOI. Les principes de ces étapes peuvent également s'appliquer à la formation d'espaceurs sur les flancs d'une grille d'un transistor de type FinFET. Les figures 7a à 7h qui seront expliquées par la suite illustrent des étapes que l'on mettra avantageusement en oeuvre pour réaliser des transistors de type FinFET.

La **figure 3a** illustre l'étape de dépôt d'une couche de nitrure 152 de silicium, d'épaisseur préférentiellement sensiblement uniforme, sur toutes les surfaces, verticales et horizontales, des dispositifs en cours de fabrication. Cette étape, qui n'est pas différente de l'étape correspondante des procédés standard et qui a déjà été mentionnée en figure 1a, se fait de préférence à l'aide d'une méthode de dépôt dite LPCVD, acronyme de l'anglais « low pressure chemical vapor deposition », c'est-à-dire « dépôt chimique en phase vapeur à faible pression ». Ce type de dépôt qui se pratique à pression sous atmosphérique permet en effet un dépôt uniforme sur toutes les surfaces quelle que soit leur orientation.

Quoi que cela ne soit pas nécessaire à la compréhension du procédé de l'invention on notera que l'électrode de grille est dans cet exemple composée à ce stade du procédé de plusieurs couches déjà mentionnées notamment dans les figures 2 pour les transistors de type FinFET. Outre la couche de silicium polycristallin 123 on retrouve dans l'empilement des couches formant la grille 120 tout d'abord la mince couche isolante d'oxyde de grille 121 à travers laquelle un champ électrique va pouvoir se développer pour créer le canal 130 de conduction sous jacent entre source et drain quand une tension électrique suffisante est appliquée sur la grille. Dans les transistors MOSFET les plus récents il est mis en oeuvre une technologie qualifiée du vocable anglais de « high-k/metal gate » c'est-à-dire que la couche diélectrique 121 est faite d'un matériau isolant à haute permittivité (high-k) couverte par une grille métallique (metal gate) représentée par la couche 122. Cette technologie a été développée notamment pour réduire les courants de fuite à travers la grille qui devenaient beaucoup trop importants en raison de la diminution de l'épaisseur de la couche diélectrique 121 jusqu'à des dimensions atomiques. À ce stade, l'empilement de couches de la grille comprend aussi un masque dur 124 de protection qui sera enlevé ultérieurement pour permettre la reprise de contact sur cette électrode. Ce masque dur, qui reste en place après gravure de la grille, est typiquement fait d'oxyde de silicium (SiO2). Son rôle est de protéger le sommet de la grille de tout dommage lors de la gravure des espaceurs.

De préférence, la couche diélectrique 121 est disposée au contact de la couche 146 formant le canal de conduction. De préférence, la couche 122 est disposée au contact de la couche 121. De préférence, la couche 123 est disposée directement au contact de l'oxyde de grille formée par la couche 121 si la couche 122 est absente ou est disposée directement au contact de la couche 122. De préférence, la couche 152 de nitrure de silicium est disposée directement au contact de la couche 123 au niveau des flancs de la grille. De préférence, la couche 152 de nitrure de silicium est disposée directement au contact de la couche 146 en matériau semiconducteur destinée à former le canal de conduction.

La **figure 3b** illustre l'étape suivante de l'invention appliquée à la réalisation de transistors FDSOI dans laquelle on procède directement à une modification 158 de la couche 152 de nitrure de silicium que l'on vient de déposer. Comme on le verra par la suite cette opération pourra facultativement avoir été précédée d'une gravure sèche conventionnelle de type CH3F/O2/He décrite précédemment.

L'étape de modification de la couche de nitrure telle que déposée, ou de la couche restante après une première gravure conventionnelle, se fait par implantation d'espèces légères également désignées ions légers. On rappelle qu'on entend par « ion léger » des ions provenant de matériaux dont le numéro atomique dans la classification périodique des éléments est faible et d'une façon générale tous les éléments que l'on peut implanter dans un matériau à graver, sans provoquer de dislocation de sa structure atomique telle qu'elle entraînerait une pulvérisation de ce dernier.

Typiquement, la modification de la couche à graver repose sur l'implantation d'espèces légères comme l'hydrogène (H) ou l'hélium (He).

Avantageusement, les paramètres d'implantation, en particulier l'énergie communiquée aux ions, la durée et la dose d'implantation sont prévus de sorte que la couche de nitrure modifiée puisse être gravée sélectivement par rapport à la couche en un matériau semi-conducteur.

Avantageusement, ces paramètres sont également réglés de manière à ce que la couche de nitrure modifiée puisse être gravée sélectivement par rapport à la portion non modifiée de la couche de nitrure.

Avantageusement, ces paramètres sont également réglés de manière à ce que la couche de nitrure modifiée puisse être gravée sélectivement par rapport à une couche faite d'un oxyde typiquement un oxyde dudit matériau semi-conducteur, cette dernière formant par exemple une couche d'oxyde de grille. Typiquement, la gravure est sélective du nitrure de silicium modifié par implantation d'H ou d'He vis-à-vis de l'oxyde de silicium.

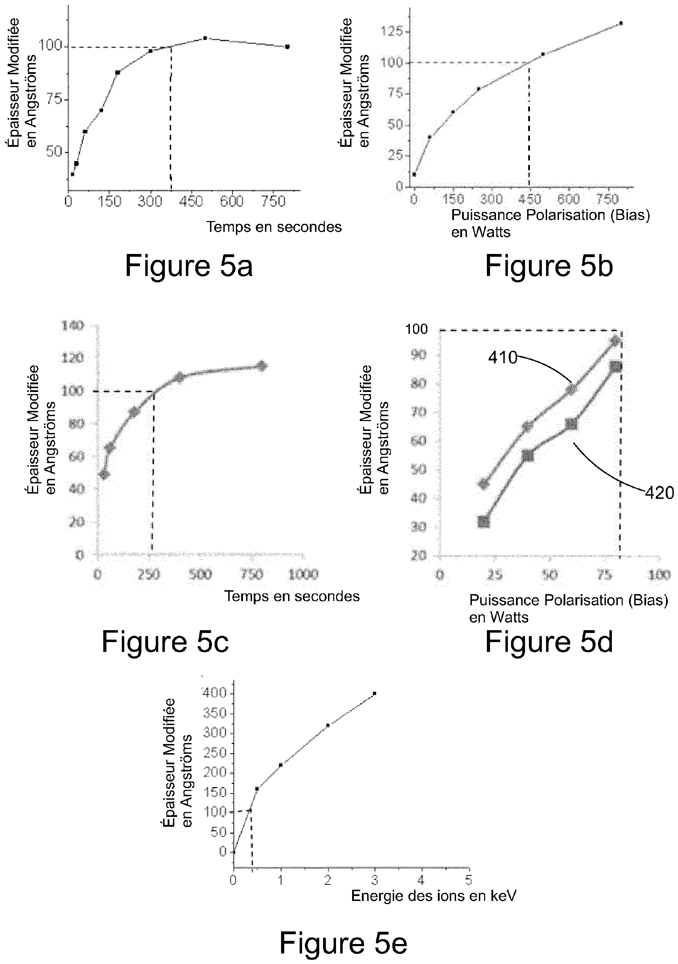

L'implantation s'effectue par exemple dans un plasma d'hydrogène gazeux (H2) ou d'hélium (He). Un exemple de mise en oeuvre de cette étape est discuté dans la figure 5. On notera ici que cette étape de modification de la couche à graver peut se pratiquer de nombreuses façons différentes en adaptant toutes sortes de moyens couramment employés par l'industrie de la microélectronique. On utilise notamment des graveurs standard dont lesquels on peut développer des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication. Enfin, l'implantation peut aussi se faire dans un implanteur standard où l'on accélère les ions dans un champ électrique pour obtenir leur implantation dans un solide.

Comme indiqué précédemment, une modification de la couche effectuée par une implantation à l'aide d'un plasma a pour avantage de permettre une implantation en continue depuis la surface libre de la couche de nitrure et sur une épaisseur faible, typiquement comprise entre 0 et 100 nm voire entre 0 et 30nm. Elle permet également de bénéficier d'une sélectivité améliorée dès le début de la gravure et d'une vitesse de gravure constante, conduisant à une précision de gravure améliorée. Elle permet également d'effectuer la modification et le retrait de la couche modifiée de nitrure dans une même enceinte.

L'emploi d'un plasma pour implanter la couche de nitrure permet ainsi de retirer une couche très fine de nitrure, typiquement comprise entre 1 et 10 nm et plus généralement entre 1 et 30 nm.

L'opération de modification est avantageusement très anisotrope pour la réalisation des espaceurs sur les flancs des grilles en raison de la directionnalité des ions du plasma ou de l'implanteur. Elle affecte donc préférentiellement les surfaces horizontales, c'est-à-dire toutes les surfaces parallèles au plan du substrat. L'épaisseur modifiée sur les surfaces horizontales 154 est ainsi nettement plus importante que sur les surfaces verticales c'est-à-dire sur toutes les surfaces perpendiculaires au plan du substrat élaboré sur lequel est disposée la grille. Ce plan est perpendiculaire au plan de la coupe représentée sur les figures 3a à 3d. Le substrat élaboré forme de préférence une plaque avec deux faces parallèles. Il se présente par exemple sous la forme d'un disque, d'un carré, d'un polygone, etc. La couche mince 146, la couche d'oxyde enterrée et le substrat massif sont disposés selon des plans parallèles. Ainsi, une surface sera qualifiée d'horizontale si elle est parallèle au plan de la couche ou des couches formant le substrat sur lequel est formé la grille et une surface sera qualifiée de verticale si elle est perpendiculaire à ce même plan.

Typiquement, une épaisseur 154 de 10 nm sur les surfaces horizontales peut être modifiée au cours de cette opération. Une épaisseur 156 allant de 1 à 3 nm de nitrure est toutefois également modifiée sur les surfaces verticales quelles que soient les conditions du plasma. Ces surfaces verticales par rapport au plan du substrat sont donc parallèles aux flancs de la grille. Les épaisseurs modifiées dépendent des conditions de mise en oeuvre, notamment des moyens employés (plasma ou implanteur) et aussi du fait que l'on désire obtenir la gravure des espaceurs en une seule étape globale de modification et de gravure ou qu'au contraire on répète ces opérations jusqu'à obtenir une gravure complète.

Ainsi, en fonction des mises en oeuvre particulières du procédé de l'invention et de l'épaisseur initiale de la couche de nitrure 152, l'étape de modification de cette couche peut affecter la totalité de cette couche où, comme représenté dans l'exemple de la figure 3b, une partie seulement de celle-ci. Dans ce cas, l'étape de modification et l'étape suivante de retrait de la couche modifiée décrite ci-après pourront être répétées jusqu'à enlèvement complet du nitrure sur toutes les surfaces horizontales.

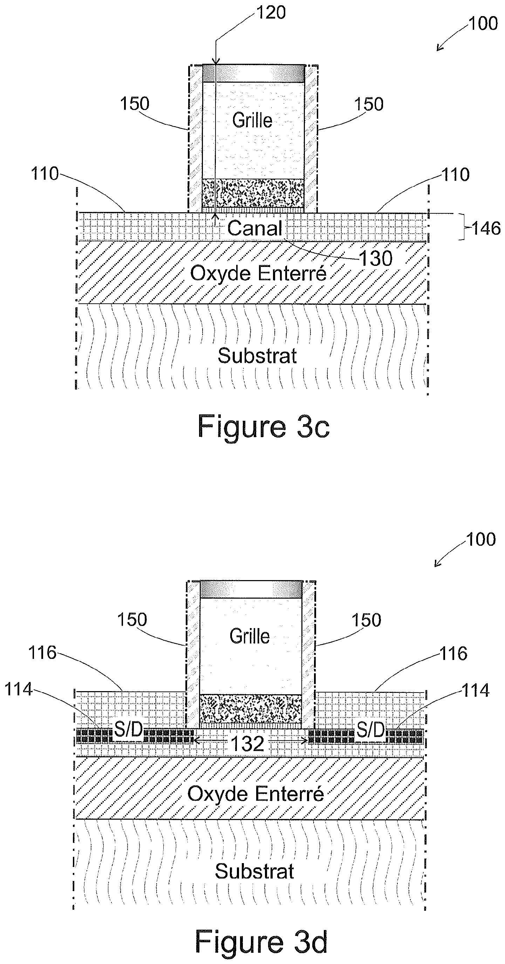

La **figure 3c** illustre le résultat final de l'étape suivante après que l'on a procédé à la gravure, c'est-à-dire au retrait de la couche modifiée et possiblement répété, d'une part, l'opération de modification décrite dans la figure précédente, et d'autre part, l'opération de retrait de la couche modifiée.

Une méthode utilisée pour le retrait de la couche modifiée 158 de nitrure de silicium consiste, comme déjà mentionné, à utiliser une solution de gravure à base d'acide fluorhydrique (HF) ou d'acide phosphorique (H3PO4). L'arrêt de la gravure se fait sur la couche de nitrure non modifiée ou sur le silicium monocristallin de la couche 146 ou encore sur le masque dur 124 au sommet des grilles. On notera ici, en référence au problème décrit dans la figure 1b, qu'il n'y a aucune consommation de silicium due à l'utilisation d'acide fluorhydrique ou d'acide phosphorique. Par ailleurs, une optimisation de l'étape de modification par implantation d'espèces légères décrite ci-dessus n'entraîne qu'une modification de la couche de nitrure et l'opération de gravure qui suit n'affecte donc pas le silicium sous jacent. Ainsi, comme représenté, Il n'y a très avantageusement aucune consommation dans les zones S/D 110 de la couche de silicium 146.

À l'issue de ces opérations il ne reste donc de la couche initiale de nitrure de silicium que des motifs verticaux, essentiellement sur les flancs de l'empilement de couches qui forment la grille 120. Ils constituent les espaceurs 150 de grille du transistor.

La **figure 3d** illustre la formation des zones de drain et de source d'un transistor de type FDSOI.

A l'issue de la dernière ou unique étape de retrait de la couche modifiée de nitrure, c'est-à-dire lorsqu'on a fini de l'enlever sur toutes les surfaces horizontales, on procède à une opération de nettoyage dite « nettoyage humide » le plus souvent qualifiée par son vocable anglais de « wet clean ». Comme on l'a déjà noté précédemment gravure humide et nettoyage humide sont des opérations similaires qui peuvent être avantageusement combinées en une seule opération.

On peut ensuite procéder à la formation des électrodes de source et de drain 110. Comme on l'a déjà mentionné, le dopage qui va délimiter source et drain et donc la longueur du canal 132 peut se faire par implantation ionique avant qu'on ne procède à une croissance épitaxiale sur ces zones afin d'augmenter leur section et diminuer leur résistance. Si le dopage est effectué avant croissance épitaxiale, comme représenté sur la figure 3d, le procédé est dit être « extension first » vocable anglais utilisé pour indiquer que les extensions (de source et de drain sous les espaceurs) sont réalisées en premier, c'est-à-dire avant croissance épitaxiale. Dans le cas contraire qui est dit être « extension last » on procède directement à l'étape de croissance épitaxiale sans dopage préalable. Le dopage des zones source/drain ne se fait qu'après croissance épitaxiale de ces zones. Dans le cas de transistors à canal de type n (nMOS), les dopants implantés sont typiquement l'arsenic (As) ou le phosphore (P). Pour les transistors à canal de type p (pMOS) les dopants sont le bore (B) ou le difluorure de bore (BF2).

Le résultat est illustré sur la figure 3d qui montre les zones source/drain dopées 114 avant croissance épitaxiale des zones source/drain surélevées 116.

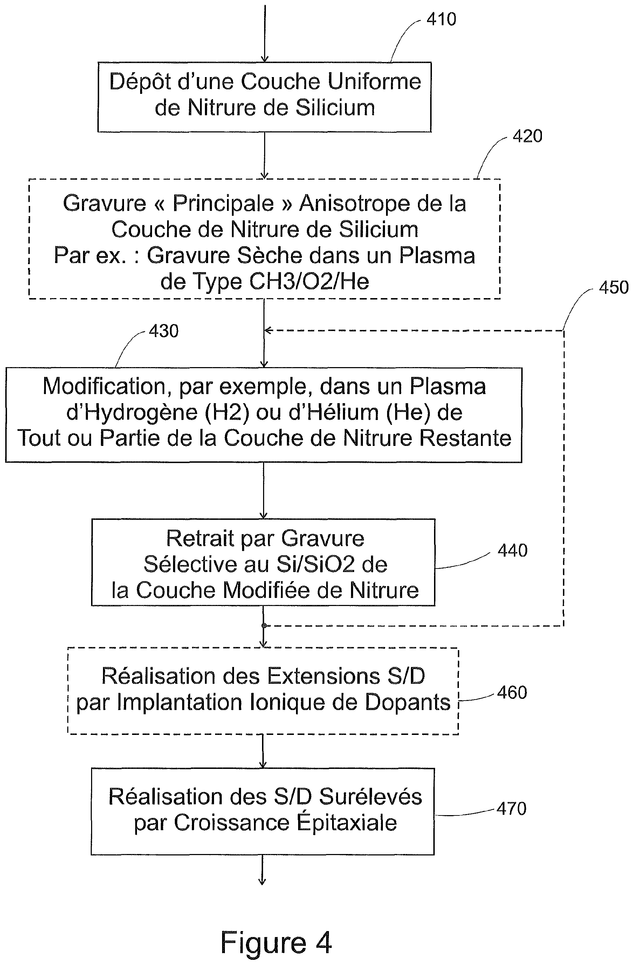

La **figure 4** résume les étapes du procédé de l'invention destinées à former des espaceurs et qui n'induisent aucun des défauts décrits notamment dans les figures 1b, 1c et 1d pour la réalisation de transistors FDSOI.

Après dépôt 410 par LPCVD d'une couche uniforme de nitrure de silicium sur toutes les surfaces des dispositifs en cours de fabrication on procède au retrait de la couche de nitrure sur les surfaces qui ne sont pas destinées à former les espaceurs. Ce retrait comprend plusieurs étapes, dont les étapes 430, 440 et optionnellement l'étape 420 préalable.

Ainsi, optionnellement, on procède à une gravure sèche conventionnelle anisotrope 420 de la couche de nitrure. Ceci est typiquement effectué dans un plasma de type CH3F/O2/He décrit précédemment. La gravure des espaceurs est ainsi, selon ce mode de réalisation optionnel et non limitatif, réalisée en deux étapes comprenant : une première étape dite de « gravure principale » et une seconde étape de finition généralement qualifiée de « surgravure » ou du terme anglophone de « over etching (OE) » ayant la même signification. C'est au cours de l'étape de surgravure (étapes 440) que l'on finira d'enlever le nitrure restant sur les surfaces horizontales, après avoir modifié (étape 430) la couche de nitrure pour éviter ou limiter les problèmes décrits dans les figures 1b à 1d.

Dans le cadre de mises en oeuvre spécifiques de l'invention on peut décider de maintenir ou non l'étape de gravure principale 420, les étapes suivantes s'appliquent alors soit sur la couche de nitrure telle que déposée ou sur la couche restante de nitrure après qu'une gravure principale a été préalablement effectuée comme dans le procédé standard de gravure des espaceurs.

Comme montré sur la figure 3b l'étape suivante 430 consiste à modifier de façon anisotrope tout ou partie 154 de la couche de nitrure restante 152 par implantation d'hydrogène (H2) ou d'hélium (He). Comme mentionné précédemment, cette implantation d'hydrogène ou d'hélium peut être réalisée dans un implanteur standard ou dans un réacteur de gravure plasma par exemple du type de ceux utilisés pour la gravure principale mentionnée ci-dessus. Suivant les applications du procédé de l'invention on pourra préférer utiliser un graveur plasma notamment pour les raisons suivantes :
- le coût de l'appareillage est moins élevé ;
- les temps de cycle de fabrication peuvent être plus courts puisque l'étape de gravure principale 420 et celle de modification de la couche de nitrure 430 peuvent alors se faire dans le même appareillage sans remise à l'air des dispositifs en cours de fabrication ;
- de plus, les implanteurs utilisés actuellement sont conçus pour des dopants tels que ceux mentionnés précédemment : As, P et BF2 qui requièrent de fortes énergies d'implantation. L'utilisation de ces implanteurs pour des espèces légères comme l'hydrogène et l'hélium nécessiterait de travailler dans des gammes d'énergie de quelques centaines d'électrons volts (eV) seulement qui sont très éloignées des conditions d'utilisation habituelles de ces équipements.

Cependant, en dépit du coût plus élevé des implanteurs et des inconvénients mentionnés ci-dessus, ceux-ci pourront être utiles et préférés, voire nécessaires, pour certaines applications comme pour la réalisation de transistors tridimensionnels de type dit FinFET représentés dans les figures 2a à 2i. Un exemple du besoin d'avoir recours à un tel moyen est illustré ci-après dans les figures 7a à 7g où plusieurs implantation sont réalisées suivant des direction d'implantation différentes.

L'étape suivante 440 est celle où l'on pratique le retrait par gravure de la couche modifiée ou tout au moins de l'épaisseur modifiée de la couche de nitrure. Pour éviter les problèmes des procédés traditionnels de gravure des espaceurs décrits dans les figures 1b à 1d il est nécessaire que la gravure de la couche modifiée soit la plus sélective possible par rapport au silicium notamment afin de ne pas attaquer le silicium monocristallin des zones source/drain avec les inconvénients et conséquences décrits dans la figure 2a.

Pour ce faire une gravure humide à base d'acide fluorhydrique (HF) ou d'acide phosphorique (H3PO4) qui, comme déjà mentionné, combine le retrait de la couche modifiée avec un nettoyage de la tranche contenant les dispositifs en cours de fabrication, est avantageusement utilisé. Cela simplifie le procédé et apporte un gain de temps.

L'épaisseur de la couche modifiée est typiquement comprise dans une gamme de valeurs allant de 1 nm à quelques dizaines de nm. Les temps de gravure peuvent aller de quelques secondes à quelques minutes. Ils sont évidemment directement dépendant de l'épaisseur qui a été modifiée. À titre d'exemple, pour enlever une épaisseur de 10 nm de nitrure modifié il faut de l'ordre de 30 secondes avec une solution d'acide fluorhydrique à 1%. Le même temps de gravure est obtenu avec de l'acide phosphorique dilué à 85%.

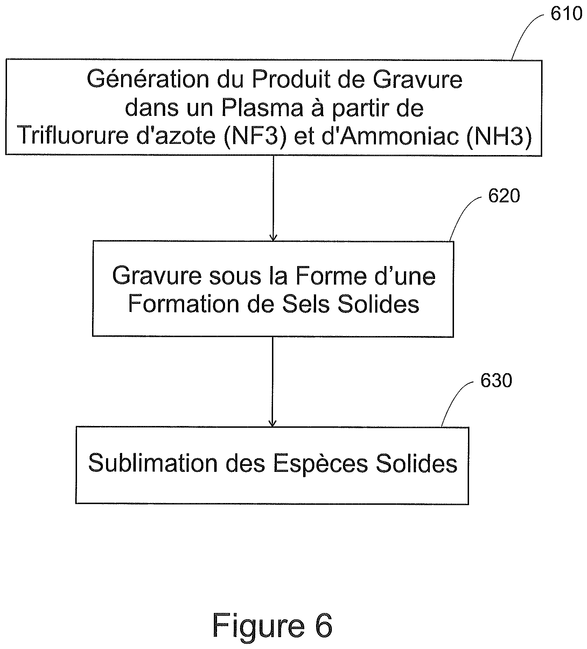

La gravure de la couche modifiée sera également aussi sélective par rapport à l'oxyde de silicium dans d'autres applications du procédé que celle servant à la réalisation des espaceurs de transistors de type FDSOI où cela n'est pas utile. C'est notamment le cas pour pouvoir réaliser des transistors tridimensionnels de type FinFET. Une gravure sèche sélective au silicium et à son oxyde (Si/SiO2) pourra alors être aussi pratiquée pour cette étape de retrait de la couche modifiée de nitrure. Ce type de gravure sèche est décrit dans la figure 6.

Comme déjà mentionné les opérations de modification 430 de la couche de nitrure et de retrait 440 de la couche modifiée peuvent optionnellement être répétées 450 jusqu'à disparition du nitrure sur toutes les surfaces horizontales.

Les étapes suivantes du procédé ne sont pas différentes de celles correspondantes des procédés standard où l'on réalise possiblement les extensions des zones source/drain 460 par implantation ionique de dopants avant croissance épitaxiale des source/drain surélevés 470 de transistors FDSOI.

Le tableau ci-après donne des conditions typiques de mise en oeuvre de l'étape 430 de modification de la couche de nitrure dans le cas d'utilisation d'un réacteur de gravure plasma standard. Ces conditions sont largement dépendantes de l'épaisseur à modifier dans la couche de nitrure. Ceci n'est qu'un exemple particulier de mise en oeuvre de l'étape 430 de modification de la couche à graver. Comme déjà mentionné précédemment, d'autres moyens peuvent être utilisés pour l'implantation des espèces légères, H ou He, servant à modifier la couche à graver. Notamment, on pourra utiliser des plasmas à faible ou haute densité, des plasmas par immersion ou des implanteurs standard.

| | |
|---|---|
| Réacteur de gravure : | N'importe quel type de dispositif de gravure sèche est potentiellement utilisable et notamment ceux dit ICP de l'anglais « inductively coupled plasma » c'est-à-dire « plasma à couplage inductif ». Les valeurs ci-dessous s'appliquent plus particulièrement à ce type de graveur. |
| Épaisseur modifiée : | de 1 nm à quelques dizaines de nm |
| Chimie | basée sur la chimie de l'hydrogène (H2) ou de l'hélium (He) |
| Puissance de la source : | 0 - 2000 W |
| Puissance de polarisation : | 20 - 2000 W |
| Pression : | 5 - 100 milli Torr |
| Température : | 10 - 100°C |
| Temps : | quelques secondes à quelques centaines de secondes |

Par exemple, pour modifier une épaisseur de 10 nm de nitrure de silicium, les conditions avec de l'hydrogène (H2) sont : flux d'hydrogène 200 sccm (centimètres cube par minute); puissance de la source = 500 W ; puissance de polarisation = 250 W; pression = 20 milli Torr; température = 40°C ; temps = 60 s. Si on utilise de l'hélium (He), la puissance de polarisation est alors de 450 W.

Comme déjà discuté l'implantation peut alternativement aussi se faire dans un implanteur conventionnel avec des énergies allant de quelques électron-volt (eV) à quelques centaines d'eV.

Les **figures 5a à 5e** donnent pour le matériau standard utilisé pour former les espaceurs, c'est-à-dire le nitrure de silicium (SiN), les épaisseurs de couches modifiées obtenues en fonction de différentes conditions de mise en oeuvre de l'étape d'implantation d'espèces légères dans un réacteur de gravure plasma standard.

Les figures 5a et 5b donnent l'épaisseur modifiée en fonction, respectivement, du temps en secondes et de la puissance de la polarisation (bias) en watts pour un graveur de type ICP et dans les conditions suivantes, pour la figure 5a :
- débit H2 de 200 sccm ; puissance de la source 500 watts ; puissance de la polarisation 150 watts ; pression 10 milli Torr ; température 50°C ;
   et pour la figure 14b :
- débit H2 de 200 sccm; puissance de la source 500 watts ; temps 60 secondes ; pression 10 milli Torr ; température 50°C ;

Les figures 5c et 5d donnent l'épaisseur modifiée en fonction, respectivement, du temps en secondes et de la puissance de la polarisation (bias) en watts pour un graveur de type dit CCP de l'anglais « capacitive coupled plasma » c'est-à-dire « plasma à couplage capacitif » et dans les conditions suivantes, pour la figure 5c :
- débit H2 de 200 sccm ; puissance de la source nulle (0 watt) ; puissance de la polarisation 40 watts ; pression 10 milli Torr ; température 50°C ;
   et pour la figure 5d :
- débit H2 de 200 sccm ; puissance de la source nulle (0 watt) ; temps 60 secondes; pression 10 milli Torr; température 50°C. Dans cette figure la courbe 410 correspond à l'implantation d'hydrogène, la courbe 420 correspond à l'implantation d'hélium.

La figure 5e correspond au cas d'un plasma par immersion. L'épaisseur implantée est donnée en fonction de l'énergie communiquée aux ions H2 en keV et pour un flux d'ions de 0,1 milli ampères par centimètre carré (mA/cm²).

La **figure 6** montre les étapes du retrait par voie sèche de la couche de nitrure de silicium qui a été modifiée par implantation, par exemple, d'hydrogène.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe du retrait par voie sèche de la couche de nitrure de silicium est identique à celui décrit dans la publication ci-dessus. La différence est que dans le cas de l'invention on ne grave pas de l'oxyde de silicium mais une couche de nitrure de silicium avec des implants d'hydrogène. Le mécanisme est toutefois le même et comprend les étapes suivantes qui s'effectuent dans une chambre de réaction où l'on forme un plasma. Les épaisseurs traitées sont typiquement comprises entre 1 nm et quelques dizaines de nanomètres.

Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 10 nm de nitrure modifié les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.

On remarquera ici qu'il existe des réacteurs de gravure permettant de réaliser une implantation, par exemple d'hydrogène, à partir d'un plasma qui peut être suivi, dans le même système, du retrait de la couche modifiée à l'aide d'une gravure sèche comme décrite ci-dessus. Ainsi il est possible dans ce cas d'enchaîner les cycles de modification et de retrait du nitrure sélectivement au Si ou SiO2 sans remise à l'air de la tranche. Ceci est une incitation supplémentaire à l'utilisation d'un réacteur de gravure pour mettre en oeuvre l'invention plutôt que d'utiliser un implanteur standard chaque fois que c'est possible.

Dans ce type de réacteur de gravure on peut également procéder au retrait de la couche modifiée à l'aide d'une gravure plasma standard. Le tableau suivant, qui concerne le nitrure de silicium (SiN), correspond à un retrait de la couche à graver après que ce matériau a été préalablement modifié dans une chambre de gravure de type ICP dans les conditions suivantes : débit de H2 200 sccm ; température du substrat 20°C ; puissance de la source contrôlant la dissociation des espèces 500 watts ; puissance de la polarisation contrôlant l'énergie communiquée aux ions 150 watts; pression 20 milli Torr ; durée 60 secondes. Cette opération est suivie d'une gravure plasma standard CH3F/O2/He. On constate que le taux de gravure du silicium modifié est augmenté de 40%.

| | | Vitesse de gravure en nm par minute |
|---|---|---|
| Couche non modifiée + gravure standard | SiN + CH3F/O2/He (ICP) | 33 |
| Couche modifiée | SiN + H2 350Wb/2min (ICP) | 0 |
| Couche modifiée + gravure standard | SiN+ H2 350Wb/2min (ICP) + CH3F/O2/He (ICP) | 46 |

En résumé, l'invention permet notamment la gravure anisotrope d'une couche sensiblement uniforme de nitrure de façon sélective vis-à-vis du silicium et de l'oxyde de silicium. Le procédé repose sur deux étapes principales comprenant :
- une étape 430 d'implantation d'hydrogène (H2) ou d'hélium (He) afin de modifier tout ou partie de la couche de nitrure ;
- une étape de retrait 440 de la couche de nitrure modifié sélectivement au silicium et/ou à son oxyde.

Cette approche s'avère particulièrement avantageuse pour former les espaceurs de transistors MOSFET.

Cette approche permet de s'affranchir notamment des problèmes de consommation de silicium et de formation de pieds de nitrure à l'interface avec le substrat SOI décrits dans les figures 1b et 1c ainsi que de limiter l'érosion des espaceurs nitrure

Pour certaines applications il est nécessaire d'avoir un contrôle très précis du « facettage », c'est-à-dire du problème exposé dans la figure 1d, qui résulte des opérations de gravure conventionnelle et qui peut donc peut être induit par l'étape de gravure principale 420 qui est comme on l'a vu optionnelle. Avantageusement, pour pallier ce problème, on évitera donc cette étape qui sera remplacée par une répétition 450 des opérations de modification 430 de la couche de nitrure et de retrait 440 de la couche modifiée comme décrit dans la figure 4, le retrait se faisant de préférence dans ce cas sous la forme d'une retrait par voie sèche comme décrit dans la figure 6 puisque, comme on la remarqué plus haut, les deux opérations peuvent se pratiquer dans le même réacteur de gravure. La gravure anisotrope d'une couche sensiblement uniforme de nitrure de façon sélective vis-à-vis du silicium et de l'oxyde de silicium trouve également pour application la réalisation de transistors tridimensionnels de type FinFET.

Pour cette dernière application (FinFET), et pour d'autres, on notera que un procédé de gravure sélective peut aussi avantageusement être employé, en combinaison avec l'utilisation d'implanteurs standard, pour pratiquer une gravure isotrope ou une gravure selon des directions privilégiées différentes comme illustré dans l'exemple des **figures 7a à 7h****.**

Ces figures décrivent une option de modification de la couche à graver qui s'applique quand on utilise un implanteur pour implanter les espèces légères lors de l'étape 430 du procédé et obtenir une gravure de plusieurs faces non parallèles entre elles en dépit du fait que le faisceau d'ions est très directionnel.

Les figures 7a et 7b décrivent le résultat d'une première étape d'implantation à partir du faisceau d'ions très directionnel 920 généré par un implanteur standard. Comme montré sur la figure 7a le bombardement des ions 920 se fait pour l'essentiel verticalement sur cette figure, c'est-à-dire perpendiculairement au plan des couches du dispositif en cours de fabrication. Seules les surfaces 2334 perpendiculaires à la direction privilégiée du faisceau (soit les surfaces horizontales tel qu'illustrées sur les figures 7a et 7b) sont alors modifiées comme montré sur la figure 7b.

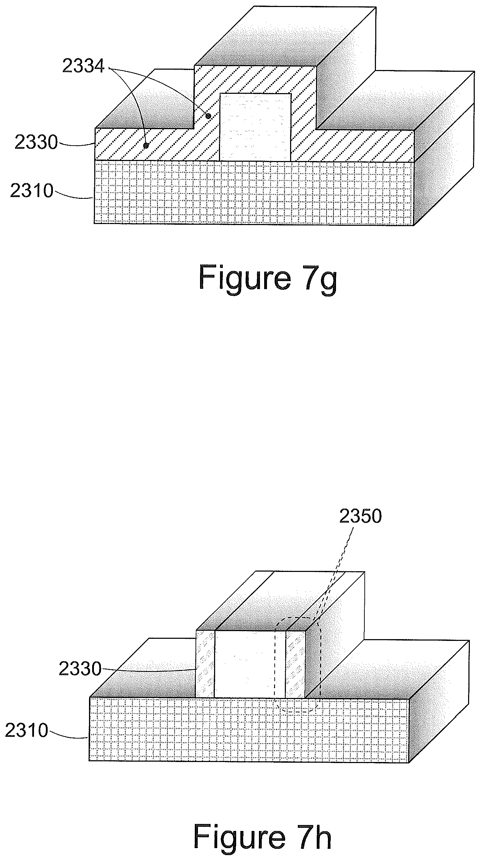

Pour pouvoir, dans un implanteur, modifier les flancs des motifs on procède ensuite, comme montré sur la figure 7c à une deuxième implantation 921 après avoir incliné 2610 la cible dans la chambre d'implantation, c'est-à-dire le substrat en cours de fabrication. Ceci afin de pouvoir exposer un flanc des motifs à graver. On tire ici avantage de ce que l'on peut, dans le cas d'un implanteur, orienter la cible au mieux, aussi bien en rotation qu'en inclinaison, pour exposer toutes les zones à graver au faisceau d'ions. Le résultat est comme montré sur la figure 7d. Le matériau à graver est modifié dans les zones exposées 2336 au bombardement directionnel de l'implanteur. Comme montré sur les figures 7e et 7f, on répète l'opération d'implantation 922 après avoir incliné le substrat 2620 afin d'exposer l'autre flanc des motifs et modifier 2338 le matériau dans les régions exposées. Les opérations ci-dessus peuvent avoir à être répétées, avec des orientations différentes, autant de fois que nécessaire pour exposer toutes les surfaces à graver. Le résultat final est comme montré sur la figure 7g. On peut alors procéder au retrait complet de la couche à graver. Il ne reste alors plus de couche 2330 sur le motif ou sur la couche 2310. Tel est le cas si le motif est un fin d'un transistor FinFET. La couche de nitrure est retirée sur les flancs et le sommet du motif ainsi que sur la couche 2310 sous jacente au motif.

De manière optionnelle, et comme mentionné précédemment, on peut choisir de contrôler précisément l'épaisseur de la couche 2330 non modifiée qui subsiste sur les flancs. Pour cela, les implantations effectuées alors que le substrat est incliné de manière à implanter les flancs, est réglée, en dose et énergie notamment, afin que seule une portion de l'épaisseur de la couche 2330 présente sur les flancs soit modifiée. Ainsi, sur les flancs, une partie seulement de l'épaisseur de cette couche 2330 est gravée lors de l'étape de retrait alors qu'en dehors des flancs, toute l'épaisseur de cette couche 2330 est gravée lors de cette étape. Le résultat obtenu est donc comme montré sur la figure 7h, une épaisseur contrôlée étant prélevée sur les flancs.

L'invention n'est pas limitée aux seuls modes et exemples de réalisation décrits ci-dessus, mais s'étend à tous les modes de réalisation entrant dans la portée des revendications.

## Revendications

1. Procédé de formation des espaceurs d'une grille (150) d'un transistor à effet de champ (100), la grille (150) étant située au dessus d'une couche (146) en un matériau semi-conducteur, comprenant une étape (410) de formation directement au contact de la couche en un matériau semi-conducteur d'une couche de nitrure (152) recouvrant la grille du transistor, le procédé étant **caractérisé en ce qu'**il comprend :
après l'étape de formation de la couche de nitrure (152), au moins une étape de modification (430) de la couche (152) de nitrure par implantation d'ions légers au sein de la couche de nitrure (152) pour former une couche modifiée (158) de nitrure, l'étape de modification étant réalisée de manière à ne pas modifier la couche de nitrure (152) sur toute son épaisseur au niveau de flancs de la grille (150) ; l'implantation étant réalisée à partir d'un plasma comprenant les ions légers ; l'étape de modification réalisée à partir d'un plasma modifie la couche de nitrure de manière continue depuis la surface de la couche de nitrure (152) et sur une épaisseur comprise entre 1 nm et 30nm ;
au moins une étape de retrait (440) de la couche modifiée (158) de nitrure à l'aide d'une gravure sélective de la couche modifiée (158) de nitrure vis-à-vis dudit matériau semiconducteur et vis-à-vis de la couche de nitrure non modifiée.

2. Procédé selon l'une quelconque des revendications précédentes dans lequel l'étape de modification réalisée à partir d'un plasma modifie la couche de nitrure de manière continue depuis la surface de la couche de nitrure (152) et sur une épaisseur comprise entre 1 nm et 10 nm.

3. Procédé selon l'une quelconque des deux revendications précédentes dans lequel le matériau semi-conducteur est à base de silicium et dans lequel l'étape de retrait (440) de la couche modifiée de nitrure est effectuée par gravure sèche sélective au matériau semi-conducteur et/ou à un oxyde du matériau semi-conducteur.

4. Procédé selon la revendication précédente dans lequel la gravure sèche est effectuée dans un plasma formé dans une enceinte confinée à partir de trifluorure d'azote (NF3) et d'ammoniac (NH3).

5. Procédé selon l'une quelconque des deux revendications précédentes dans lequel la gravure sèche comprend :
une étape de gravure (620) consistant en la formation de sels solides ;
une étape de sublimation (630) des espèces solides.

6. Procédé selon l'une quelconque des revendications précédentes dans lequel les étapes de modification et de retrait de la couche de nitrure sont réalisées dans un même réacteur plasma.

7. Procédé selon l'une quelconque des revendications 1 ou 2 dans lequel le matériau semi-conducteur est du silicium et dans lequel l'étape de retrait (440) de la couche de nitrure modifiée est effectuée par gravure humide sélectivement au silicium (Si) et/ou à l'oxyde de silicium (SiO2) (121, 740).

8. Procédé selon l'une quelconque des revendications précédentes dans lequel l'étape de modification (430) de la couche de nitrure est précédée d'une étape principale de gravure anisotrope (420) et dans lequel l'étape principale de gravure anisotrope (420) comprend en une gravure sèche réalisée dans un plasma à base de fluorure de méthyle (CH3F)

9. Procédé selon l'une quelconque des revendications précédentes comprenant une unique étape de modification (430) effectuée de sorte à modifiée la couche de nitrure dans toute son épaisseur sur toutes les surfaces parallèles au plan d'un substrat sur lequel repose la grille (150) et à ne pas modifier la couche de nitrure dans toute son épaisseur sur les surfaces perpendiculaires à ce plan.

10. Procédé selon l'une quelconque des revendications 1 à 8 comprenant plusieurs séquences comprenant chacune une étape de modification (430) et une étape de retrait (440), et dans lequel au cours d'au moins l'une des étapes de modification (430), seule une partie de l'épaisseur de la couche de nitrure est modifiée.

11. Procédé selon l'une quelconque des revendications précédentes dans lequel la grille (150) du transistor est située sur un empilement de couches formant un substrat élaboré de type silicium sur isolant (SOI).

12. Procédé selon l'une quelconque des revendications précédentes, dans lequel le matériau semi-conducteur est pris parmi: le silicium (Si), le germanium (Ge), le silicium-germanium (SiGe) et dans lequel les ions légers sont pris parmi l'hélium (H) et l'hydrogène (H2).

13. Procédé selon l'une quelconque des revendications précédentes, dans lequel le transistor est un transistor de type FDSOI ou de type FinFET.

## Patentansprüche

1. Verfahren zum Bilden der Spacer eines Gates (150) eines Feldeffekttransistors (100), wobei das Gate (150) oberhalb einer Schicht (146) aus einem Halbleitermaterial liegt, umfassend einen Schritt (410) des Bildens, direkt im Kontakt mit der Schicht aus einem Halbleitermaterial, einer Nitridschicht (152), die das Gate des Transistors bedeckt, wobei das Verfahren **dadurch gekennzeichnet ist, dass** es umfasst:
nach dem Schritt des Bildens der Nitridschicht (152) mindestens einen Schritt des Modifizierens (430) der Nitridschicht (152) durch Implantieren von leichten Ionen in die Nitridschicht (152), um eine modifizierte Nitridschicht (158) zu bilden, wobei der Modifizierschritt in der Weise ausgeführt wird, dass die Nitridschicht (152) im Bereich von Seitenwänden des Gates (150) nicht auf ihrer gesamten Dicke modifiziert wird; wobei das Implantieren anhand eines Plasmas ausgeführt wird, das die leichten Ionen umfasst; wobei der anhand eines Plasmas ausgeführte Modifizierschritt die Nitridschicht ab der Oberfläche der Nitridschicht (152) und auf einer Dicke im Bereich zwischen 1 nm und 30 nm in kontinuierlicher Weise modifiziert;
mindestens einen Schritt des Entfernens (440) der modifizierten Nitridschicht (158) mithilfe einer selektiven Ätzung der modifizierten Nitridschicht (158) gegenüber dem Halbleitermaterial und gegenüber der nicht modifizierten Nitridschicht.

2. Verfahren nach einem der vorstehenden Ansprüche, wobei der anhand eines Plasmas ausgeführte Modifizierschritt die Nitridschicht ab der Oberfläche der Nitridschicht (152) und auf einer Dicke im Bereich zwischen 1 nm und 10 nm in kontinuierlicher Weise modifiziert.

3. Verfahren nach einem der zwei vorstehenden Ansprüche, wobei das Halbleitermaterial auf Basis von Silizium ist und wobei der Schritt des Entfernens (440) der modifizierten Nitridschicht durch selektives Trockenätzen des Halbleitermaterials und/oder eines Oxids des Halbleitermaterials erfolgt.

4. Verfahren nach dem vorstehenden Anspruch, wobei das Trockenätzen in einem Plasma erfolgt, das in einem geschossenem Raum anhand von Stickstofftrifluorid (NF3) und Ammoniak (NH3) gebildet wird.

5. Verfahren nach einem der zwei vorstehenden Ansprüche, wobei das Trockenätzen umfasst:
einen Ätzschritt (620), der in der Bildung von festen Salzen besteht;
einen Schritt des Sublimierens (630) der festen Spezies.

6. Verfahren nach einem der vorstehenden Ansprüche, wobei die Schritte des Modifizierens und des Entfernens der Nitridschicht in ein und demselben Plasmareaktor ausgeführt werden.

7. Verfahren nach einem der Ansprüche 1 oder 2, wobei das Halbleitermaterial Silizium ist und wobei der Schritt des Entfernens (440) der modifizierten Nitridschicht durch selektives Nassätzen des Siliziums (Si) und/oder des Siliziumoxids (SiO2) (121, 740) erfolgt.

8. Verfahren nach einem der vorstehenden Ansprüche, wobei dem Schritt des Modifizierens (430) der Nitridschicht ein Hauptschritt des anisotropen Ätzens (420) vorausgeht und wobei der Hauptschritt des anisotropen Ätzens (420) ein Trockenätzen umfasst, das in einem Plasma auf Basis von Methylfluorid (CH3F) ausgeführt wird.

9. Verfahren nach einem der vorstehenden Ansprüche, umfassend einen einzigen Modifizierschritt (430), der derart erfolgt, dass die Nitridschicht auf allen den zu der Ebene eines Substrats, auf welchem das Gate (150) aufliegt, parallelen Oberflächen in ihrer gesamten Dicke modifiziert wird, und die Nitridschicht auf den zu dieser Ebene senkrechten Oberflächen nicht in ihrer gesamten Dicke modifiziert wird.

10. Verfahren nach einem der Ansprüche 1 bis 8, umfassend mehrere Sequenzen, die jede einen Modifizierschritt (430) und einen Entfernschritt (440) umfassen, und wobei im Laufe von mindestens einem der Modifizierschritte (430) nur ein Teil der Dicke der Nitridschicht modifiziert wird.

11. Verfahren nach einem der vorstehenden Ansprüche, wobei das Gate (150) des Transistors auf einem Schichtenstapel liegt, der ein ausgeformtes Substrat vom Typ Silizium-auf-Isolator (SOI) bildet.

12. Verfahren nach einem der vorstehenden Ansprüche, wobei das Halbleitermaterial ausgewählt ist aus: Silizium (Si), Germanium (Ge), Siliziumgermanium (SiGe), und wobei die leichten Ionen aus Helium (H) und Wasserstoff (H2) ausgewählt sind.

13. Verfahren nach einem der vorstehenden Ansprüche, wobei der Transistor ein Transistor vom Typ FDSOI oder vom Typ FinFET ist.

## Claims

1. Method for forming spacers of a transistor gate (150) of a field effect transistor (100), the gate (150) being located above a layer (146) in a semiconductor material, comprising a step (410) of forming directly in contact with the layer in a semiconductor material of a nitride layer (152) covering the gate of the transistor, with the method being **characterised in that** it comprises:
after the step of forming the dielectric layer (152), at least one modification step (430) of the nitride layer (152) by implanting light ions in the nitride layer (152) in order to form a modified nitride layer(158), with the modification step being carried out in such a way as to not modify the nitride layer (152) over its entire thickness on the sidewalls of the gate (150); with the implantation being carried out using a plasma comprising light ions; the modification step carried out using a plasma modifies the nitride layer continuously from the surface of the nitride layer (152) and over a thickness between 1 nm and 30 nm;
at least one step of removing (440) of the modified nitride layer (158) using a selective etching of the modified nitride layer (158) opposite said semiconductor material and opposite the non-modified nitride layer.

2. Method as claimed in any preceding claim wherein the modification step carried out using a plasma modifies the nitride layer continuously from the surface of the nitride layer (152) and over a thickness between 1 nm and 10 nm.

3. Method according to any of the two preceding claims wherein the semi-conductor material has a silicon base and wherein the step of removing (440) of the modified nitride layer is carried out by dry etching selective to the semi-conductor material and/or to an oxide of the semi-conductor material.

4. Method as claimed in the preceding claim wherein the dry etching is carried out in a plasma formed in a confined chamber using nitrogen trifluoride (NF3) and ammonia (NH3).

5. Method according to any of the two preceding claims wherein the dry etching comprises:
a step of etching (620) consisting in the forming of solid salts;
a step of sublimation (630) of the solid species.

6. Method as claimed in any preceding claim wherein the steps of modification and of removing the nitride layer are carried out in the same plasma reactor.

7. Method according to any of claims 1 or 2 wherein the semi-conductor material is silicon and wherein the step of removing (440) the modified nitride layer is carried out by wet etching selectively to the silicon (Si) and/or to silicon oxide (SiO2) (121,740).

8. Method as claimed in any preceding claim wherein the modification step (430) of the nitride layer is preceded by a main step of anisotropic etching (420) and wherein the main step of anisotropic etching (420) comprises a dry etching carried out in a plasma with a methyl fluoride (CH3F) base.

9. Method as claimed in any preceding claim comprising a single modification step (430) carried out in such a way as to modify the nitride layer over its entire thickness over all of the surfaces parallel to the plane of a substrate whereon the gate (150) rests and to not modify the nitride layer over its entire thickness on the surfaces perpendicular to this plane.

10. Method according to any of claims 1 to 8 comprising several sequences each comprising a modification step (430) and a step of removing (440), and wherein during at least one of the modification steps (430), only a portion of the thickness of the nitride layer is modified.

11. Method as claimed in any preceding claim wherein the gate (150) of the transistor is located on a stack of layers forming an elaborated substrate of the silicon-on-insulator (SOI) type.

12. Method as claimed in any preceding claim, wherein the semi-conductor material is taken from: silicon (Si), germanium (Ge), silicon-germanium (SiGe) and wherein the light ions are taken from helium (H) and hydrogen (H2).

13. Method as claimed in any preceding claim, wherein the transistor is a transistor of the FDSOI type or of the FinFET type.
